(19) 

**Europäisches Patentamt**

**European Patent Office**

**Office européen des brevets**

(11) **EP 4 697 063 A1**

(12) **EUROPÄISCHE PATENTANMELDUNG**

(43) Veröffentlichungstag:
   **18.02.2026  Patentblatt 2026/08**

(21) Anmeldenummer: **24194678.9**

(22) Anmeldetag: **14.08.2024**

(51) Internationale Patentklassifikation (IPC):
   **G01S 7/4865** (2020.01)    **G04F 10/00** (2006.01)

(52) Gemeinsame Patentklassifikation (CPC):
   **G01S 7/4865; G04F 10/005; H03M 7/00;**
   H03K 5/133

(84) Benannte Vertragsstaaten:
   **AL AT BE BG CH CY CZ DE DK EE ES FI FR GB GR HR HU IE IS IT LI LT LU LV MC ME MK MT NL NO PL PT RO RS SE SI SK SM TR**
   Benannte Erstreckungsstaaten:
   **BA**
   Benannte Validierungsstaaten:
   **GE KH MA MD TN**

(71) Anmelder: **Triple-IN GmbH**
   **22399 Hamburg (DE)**

(72) Erfinder:
   • **Hipp, Johann**
    **22391 Hamburg (DE)**
   • **Jensen, Nils**
    **23843 Bad Oldesloe (DE)**
   • **Carboni, Stefano**
    **22457 Hamburg (DE)**

(74) Vertreter: **Pavant Patentanwälte PartGmbB**
   **Ballindamm 3**
   **20095 Hamburg (DE)**

(54) **BESTIMMEN VON ZEITINFORMATION AUS EINEM PULSSIGNAL**

(57)    Ein Verfahren zum Bestimmen von Zeitinformation aus einem Pulssignal einer Time-of-Flight-Messung weist zumindest folgende Schritte auf: Filtern des Pulssignals mit mehreren hintereinandergeschalteten Verzögerungselementen; Erzeugen einer Bitfolge, indem das Pulssignal zwischen den Verzögerungselementen in Abhängigkeit einer periodischen Zeitreferenz abgetastet wird; Erzeugen von mehreren Codewörtern, die jeweils einem von mehreren aufeinanderfolgenden Blöcken der Bitfolge zugeordnet sind, wobei die Codewörter jeweils eine Anzahl gleicher aufeinanderfolgender Bitzustände des zugeordneten Blocks repräsentieren, und wobei den Codewörtern jeweils eine Bitzustandsinformation des zugeordneten Blocks hinzugefügt wird; und Bestimmen der Zeitinformation auf der Grundlage der mehreren Codewörter in Abhängigkeit von der Zeitreferenz.

Fig. 1

EP 4 697 063 A1

**Beschreibung**

Die vorliegende Erfindung betrifft ein Verfahren sowie eine Messvorrichtung zum Bestimmen von Zeitinformation aus Pulssignalen, insbesondere im Zusammenhang von Time-of-Flight-(ToF)-Messungen.

ToF-Messungen dienen zur Bestimmung von Entfernungswerten auf der Grundlage von Pulslaufzeiten zwischen Sendepulsen und reflektierten Empfangspulsen. Bei Anwendung entsprechender Messverfahren in hochperformanten 3D-Scannern sind zur Erzeugung von hochaufgelösten Entfernungsbildern neben einer hohen Messgenauigkeit auch eine möglichst hohe Messgeschwindigkeit von Bedeutung. Dennoch sollen die Kosten für die erforderliche Hardware so gering wie möglich sein. Weiterhin wird die Einhaltung einer hohen Messgenauigkeit auch bei großen Messdistanzen sowie unter nicht optimalen Umgebungsbedingungen gefordert (z.B. bei wetterbedingtem Niederschlag bei Anwendungen im Freien).

Zur Befriedigung der gewünschten Eigenschaften ist es notwendig, die relevanten Zeitinformationen aus den gemessenen Pulssignalen mit hoher Genauigkeit und Geschwindigkeit zu bestimmen. Die Zeitinformationen betreffen insbesondere die zeitliche Position von spezifischen Signalpunkten, um Zeitabstände zwischen Sende- und reflektierten Empfangspulsen zu bestimmen und diese in Entfernungswerte umzurechnen. Andererseits können Pulsbreiten von ein oder mehreren Empfangspulsen ermittelt werden, um die Empfangspulse auch bei niedrigen Signal-zu-Rausch-Verhältnissen genau zu lokalisieren und auf diese Weise eine hohe Messgenauigkeit zu erzielen.

Entsprechende Verfahren sind von der Anmelderin z.B. in den Patentveröffentlichungen EP 1 522 870 A1 und EP 1 901 093 B1 offengelegt, auf die hiermit Bezug genommen wird.

Es ist eine Aufgabe der Erfindung, Zeitinformation aus ToF-Pulssignalen mit höherer Messgeschwindigkeit und Messgenauigkeit zu bestimmen.

Die Aufgabe wird gelöst durch die Gegenstände der unabhängigen Ansprüche.

Gemäß einem ersten Aspekt wird ein Verfahren zum Bestimmen von Zeitinformation aus einem Pulssignal beschrieben, das eine ToF-Messung repräsentiert. Das Verfahren weist zumindest folgende Schritte auf: Filtern des Pulssignals mit mehreren hintereinandergeschalteten Verzögerungselementen; Erzeugen einer Bitfolge, indem das Pulssignal zwischen den Verzögerungselementen in Abhängigkeit einer periodischen Zeitreferenz abgetastet wird; Erzeugen von mehreren Codewörtern, die jeweils einem von mehreren aufeinanderfolgenden Blöcken der Bitfolge zugeordnet sind, wobei die Codewörter jeweils eine Anzahl gleicher aufeinanderfolgender Bitzustände des zugeordneten Blocks repräsentieren, und wobei den Codewörtern jeweils eine Bitzustandsinformation des zugeordneten Blocks hinzugefügt wird. Die Zeitinformation wird nachfolgend auf der Grundlage der mehreren Codewörter in Abhängigkeit von der Zeitreferenz bestimmt.

Das Verfahren ermöglicht eine besonders effiziente und gleichzeitig zuverlässige zeitliche Auswertung des Pulssignals. Hierfür kann das Verfahren einerseits vorteilhaft von ein oder mehreren integrierten Schaltungen ausgeführt werden. Andererseits werden die für jeden Abtastzeitpunkt erhaltenen Bitfolgen des Pulssignals durch Codewörter besonders kompakt, d.h. mit deutlich verringerter Datenmenge codiert. Gleichzeitig wird durch die Codewörter eine zusätzliche Bitzustandsinformation codiert, die es ermöglicht, gegenläufige Pulse (d.h. z.B. Up- und Down-Events) mit einer einzigen Verzögerungsleitung zu identifizieren und in zeitlicher Hinsicht zu vermessen.

Konventionell werden mindestens zwei Verzögerungsleitungen parallel betrieben, um die in einem Pulssignal enthaltenen Up- und Down-Events durch separate Verzögerungsleitungen auszuwerten. Bei dem hier beschriebenen Verfahren sind die mit einer einzigen Verzögerungsleitung erzeugten Codewörter jedoch so konstruiert, dass alle für die ToF-Messung relevanten Zeitinformationen des Pulssignals unmittelbar effizient, zuverlässig und vollständig bestimmt werden können.

Ausführungsformen der Erfindung sind in den abhängigen Ansprüchen, der Beschreibung und den Figuren offenbart.

Nach einer ersten Ausführungsform werden zumindest das Filtern des Pulssignals, das Erzeugen der Bitfolge sowie das Erzeugen der Codewörter von einem ersten logischen Block eines integrierten Schaltkreises ausgeführt. Der integrierte Schaltkreis ist vorzugsweise durch ein Field Programmable Gate Array (FPGA) gebildet. Weitere Schritte des Verfahrens, insbesondere betreffend das Bestimmen der Zeitinformation, können von einem zweiten logischen Block des integrierten Schaltkreises ausgeführt werden, der die Codewörter von dem ersten logischen Block empfängt und verarbeitet. Die Codewörter können wegen der beschriebenen Konstruktion der Codewörter besonders schnell und zuverlässig übertragen werden, sodass die Messgeschwindigkeit und Zuverlässigkeit der ToF-Messung erhöht wird.

Der erste logische Block weist zur Abtastung des Pulssignals vorzugsweise eine Vielzahl von Abtastelementen auf, insbesondere eine Vielzahl von D-Flip-Flops, die den jeweiligen Pegel des Pulssignals zwischen den Verzögerungselementen in Abhängigkeit der periodischen Zeitreferenz mit jeweils ein Bit abtasten. Die D-Flip-Flops speichern somit für das Pulssignal zu jedem Takt der Zeitreferenz eine Vielzahl von Bits ab, die für jeden Takt eine Bitfolge bilden.

Nach einer weiteren Ausführungsform umfassen zumindest einige der Codewörter jeweils zwei Teilcodewörter. Ein erstes Teilcodewort weist vorzugsweise eine Binärzahl auf, welche die Anzahl gleicher aufeinanderfolgender Bitzustände des zugeordneten Blocks angibt. Beispielsweise kann das erste Teilcodewort die Anzahl von 1-Bits oder 0-Bits als Binärzahl angeben und insbesondere ausschließlich durch die Binärzahl gebildet sein.

Ein zweites Teilcodewort gibt die dem jeweiligen Codewort hinzuzufügende Bitzustandsinformation des Blocks an. Die Bitzustandsinformation kann für sich genommen oder in Kombination mit dem ersten Teilcodewort die Richtung eines Bitzustandswechsels innerhalb des Blocks angeben (Wechsel von 0 auf 1 oder von 1 auf 0). Außerdem kann die Bitzustandsinformation in Kombination mit dem ersten Teilcodewort zur Positionsbestimmung eines Bitzustandswechsels innerhalb des Blocks herangezogen werden.

Das zweite Teilcodewort weist vorzugsweise zumindest ein vorbestimmtes Bit des zugeordneten Blocks auf oder ist durch dieses vorbestimmte Bit gebildet. In bevorzugter Ausführungsform kann das zweite Teilcodewort durch das erste Bit und/oder das letzte Bit des zugeordneten Blocks gebildet sein. Optional kann das zweite Teilcodewort zusätzlich ein Prüfsummenbit aufweisen, das vorzugsweise durch das letzte Bit der Bitfolge gebildet wird und eine Fehlerkorrektur ermöglicht.

Die beschriebene Codierung mit zwei Teilcodewörtern ist besonders effizient, wenn die Blöcke jeweils maximal einen Bitzustandswechsel aufweisen. Dies bedeutet, dass die Blöcke jeweils aus genau einem Teilblock von 1-Bits und genau einem Teilblock von 0-Bits verkettet sind oder entweder ausschließlich 1-Bits oder ausschließlich 0-Bits aufweisen. Die Blöcke bilden in diesem Fall unäre Bitwörter, deren etwaige Bitzustandswechsel hinsichtlich der Bitposition innerhalb des Blocks durch die beschriebene Verkettung von Teilcodewörtern exakt und komprimiert beschrieben werden kann.

Nach einer weiteren Ausführungsform ist die Länge der Codewörter jeweils kleiner als die Länge der zugeordneten Blöcke, um die Datenmenge der Bitfolge zu komprimieren. Die Länge der Codewörter und die Länge der zugeordneten Blöcke sind vorzugsweise jeweils konstant, wodurch sowohl die Codierung und als auch die nachfolgende Decodierung effizient und mit Fehlerkorrektureigenschaften ausgeführt werden können. Die Länge der Codewörter beträgt gemäß einer Ausführungsform jeweils 8 Bit, die zusammen 1 Byte bilden und effizient übertragen werden können. Die Länge der Blöcke kann jeweils 40 Bit betragen.

Nach einer weiteren Ausführungsform werden zur Bestimmung der Zeitinformation zumindest folgende Schritte ausgeführt: Ermitteln, in Abhängigkeit der mehreren Codewörter, eines ersten Verzögerungselements, das mit einem ersten Bitzustandswechsel der Bitfolge korrespondiert und einen ersten Puls des Pulssignals repräsentiert; Bestimmen einer ersten Zeitdauer, indem vorbestimmte Verzögerungszeiten des ersten Verzögerungselements und aller vorgeschalteten Verzögerungselemente addiert werden; Ermitteln, in Abhängigkeit der mehreren Codewörter, eines zweiten Verzögerungselements, das mit einem zweiten Bitzustandswechsel der Bitfolge korrespondiert und einen zweiten Puls des Pulssignals repräsentiert, wobei der zweite Bitzustandswechsel ausweislich der Bitzustandsinformationen der Codewörter gegenläufig zu dem ersten Bitzustandswechsel ist; Bestimmen einer zweiten Zeitdauer, indem vorbestimmte Verzögerungszeiten des zweiten Verzögerungselements und aller vorgeschalteten Verzögerungselemente addiert werden.

Vorzugsweise umfasst das Verfahren außerdem, dass ein Zeitabstand zwischen dem ersten Bitzustandswechsel und dem zweiten Bitzustandswechsel bestimmt wird, z.B. indem die erste Zeitdauer und die zweite Zeitdauer voneinander subtrahiert werden.

Die Codewörter geben anhand der Anzahl aufeinanderfolgender Bitzustände (z.B. die Anzahl aufeinanderfolgender 1-Bits) und der zusätzlichen Bitzustandsinformation unter anderem Auskunft über die Position der jeweiligen Bitzustandswechsel. Diese Bitposition kann unmittelbar dem bei der Abtastung unmittelbar vorgeschalteten Verzögerungselement zugeordnet werden. Durch Addition der Verzögerungszeit dieses Verzögerungselements sowie aller vorgeschalteten Verzögerungselemente kann der Zeitpunkt des Bitzustandswechsels in Bezug auf den Beginn der Abtastperiode angegeben werden. Die Summe der Verzögerungszeiten repräsentiert folglich einen ersten Zeitwert, der auch als Feinwert bezeichnet werden kann (Zeitpunkt innerhalb einer Abtastperiode). Die betreffende Abtastperiode repräsentiert hingegen einen zweiten Zeitwert, der als Grobwert bezeichnet werden kann (Zeitpunkt in Bezug auf die Zeitreferenz bzw. Systemzeit). Durch Kombination (z.B. Addition) des Feinwerts und des Grobwerts kann somit für jeden Bitzustandswechsel der Zeitpunkt der korrespondierenden Pulsflanke im Pulssignal unmittelbar auf der Grundlage der Codewörter, den vorbestimmten Verzögerungszeiten und der Zeitreferenz bestimmt werden. Für aufeinanderfolgende Bitzustandswechsel können auf diese Weise, wie beschrieben, durch Subtraktion die Zeitabstände zwischen den korrespondierenden Pulsflanken bestimmt werden.

Vorzugsweise ist jede der vorbestimmten Verzögerungszeiten einem der Verzögerungselemente zugeordnet. Die vorbestimmten Verzögerungszeiten geben jeweils eine Zeitdauer an, um die das Pulssignal bei der Filterung von dem betreffenden Verzögerungselement verzögert wird. Dementsprechend ergibt sich die Gesamtzeitdauer, die das Pulssignal bis zum Erreichen des betreffenden Verzögerungselements benötigt, durch Addition der Verzögerungszeiten der bis dahin durchlaufenen Verzögerungselemente. Vorzugsweise sind die vorbestimmten Verzögerungszeiten für eine höhere Genauigkeit gegenüber Nennverzögerungszeiten der Verzögerungselemente kalibriert.

Nach einer weiteren Ausführungsform wird das Pulssignal vor der sukzessiven Verzögerung erzeugt, indem ein Empfangssignal der ToF-Messung mit einem Komparator gefiltert wird. Das Pulssignal umfasst somit typischerweise eine Pulskette mit mehreren positiven und negativen Pulsflanken. Eine derartige Signalfilterung ist z.B. in den Dokumenten EP 1 522 870 A1 und EP 1 901 093 B1 beschrieben. Auf diese Dokumente wird hiermit Bezug genommen.

Das Pulssignal kann zusätzlich zu dem Empfangssignal auch ein oder mehrere Sendepulse aufweisen, die zur unmittelbaren Bestimmung der Pulslaufzeiten in dem Pulssignal aufgenommen sind.

Die Offenbarung erstreckt sich auch auf eine Messeinrichtung, die dazu angepasst ist, das Verfahren nach einer der beschriebenen Ausführungsformen auszuführen.

Die Messeinrichtung umfasst vorzugsweise einen integrierten Schaltkreis mit einem ersten logischen Block und wenigstens einem zweiten logischen Block, wobei der erste logischen Block mehrere hintereinandergeschaltete Verzögerungselemente zur Filterung des Pulssignals sowie mehrere Flipflops zur Erzeugung einer Bitfolge aufweist, die durch Abtastung des Pulssignals zwischen den Verzögerungselementen erhalten wird. Der zweite logische Block ist dazu angepasst, Zeitinformation auf der Grundlage mehrerer Codewörter zu bestimmen. Die Codewörter sind jeweils einem von mehreren aufeinanderfolgenden Blöcken der Bitfolge zugeordnet und repräsentieren jeweils eine Anzahl gleicher aufeinanderfolgender Bitzustände sowie eine Bitzustandsinformation des zugeordneten Blocks.

Der integrierte Schaltkreis ist vorzugsweise durch ein Field Programmable Gate Array (FPGA) gebildet, der eine besonders effiziente, robuste und kostengünstige Implementierung der betreffenden Verfahrensschritte ermöglicht.

Vorzugsweise weist das FPGA mehrere Verzögerungsleitungen auf, die jeweils mehrere hintereinandergeschaltete Verzögerungselemente aufweisen. Die in Abhängigkeit von der Zeitreferenz gefilterten Pulssignale werden jeweils parallel mit einer der Verzögerungsleitungen verarbeitet und abgetastet, um für jedes Pulssignal die Up- und Down-Events jeweils als Summe der vorbestimmten Verzögerungszeiten (Delay-Zeiten) zu bestimmen. Die Zeitpunkte der Up- und Down-Events können auf diese Weise direkt als digitale Werte gemessen und im Rahmen der ToF-Messung für die Entfernungswertbestimmung weiterverarbeitet werden.

Die Messeinrichtung kann mit Vorteil in einem ToF-Scanner zur Aufnahme von jeweils eine Vielzahl von Entfernungsbildpunkten aufweisenden Entfernungsbildern verwirklicht sein. Der ToF-Scanner umfasst eine Mehrzahl von in einem Array angeordneten Sendern jeweils zur Aussendung von elektromagnetischer Strahlung in einen Aufnahmebereich und zumindest eine Empfangseinrichtung zur Detektion von aus dem Aufnahmebereich reflektierter Strahlung. Die Messeinrichtung dient in dem ToF-Scanner zum Bestimmen von Zeitinformation aus einem Pulssignal, das eine ToF-Messung repräsentiert und herangezogen wird, um jeweils einen Entfernungsbildpunkt bildende Entfernungen von Objekten zu bestimmen, an denen die ausgesandte Strahlung reflektiert wird.

Gemäß einer bevorzugten Ausführungsform ist die Messeinrichtung als Ein-Chip-System ausgebildet, d.h. alle Komponenten der Messeinrichtung sind auf einem Chip zusammengefasst. Dies begünstigt eine hohe Messgeschwindigkeit und niedrige Herstellungskosten. Vorteilhaft können auch weitere elektronische Komponenten der Vorrichtung, wie z.B. die Sender und Empfänger auf dem Chip integriert sein, um die Vorrichtung insgesamt besonders kompakt und mit geringem Gewicht auszubilden. Die Sender sind vorzugsweise durch Laserdioden gebildet.

Die offenbarten Aspekte sind besonders geeignet für hochperformante ToF-Anwendungen, die eine sehr hohe Messgeschwindigkeit erfordern. Beispielsweise kann bei Anwendung in einem LiDAR-Scanner die Pulssendefrequenz bei 200 kHz liegen, wobei Entfernungen bis zu 1000 m gemessen werden sollen. Der Zeitabstand zwischen aufeinanderfolgenden Sendepulsen liegt dann bei 5 $\mu$s (= 1/200 kHz) und die Pulslaufzeit (Round-Trip-Zeit) bei 6,6 $\mu$s (= 2 1000 m / (300.000.000 m/s)). Eine verarbeitungsbedingte Latenz bis zum Vorliegen der Zeit- und Entfernungswerte ist bei dieser Messfrequenz regelmäßig sehr relevant und deswegen zu minimieren. Es ist insofern von besonderem Vorteil, wenn mit einer einzelnen Verzögerungsleitung Up- und Down-Events eines Pulssignals unmittelbar digital erfasst und bezüglich der relevanten Zeitabstände direkt mit hoher Genauigkeit ausgewertet werden können. Der parallele Einsatz einer Vielzahl von Verzögerungsleitungen führt mit dem beschriebenen Verfahren zu einer insgesamt schnelleren und gleichzeitig genauen ToF-Messung.

Die beschriebenen Aspekte der Offenbarung werden nachfolgend unter Bezugnahme auf die Zeichnungen rein beispielhaft beschrieben, wobei weitere vorteilhafte Merkmale und Ausführungsformen offenbart sind.

Die Figuren zeigen im Einzelnen:

Fig. 1       ein Blockschaltbild für ein Verfahren zur Bestimmung von Zeitabständen aus einem Pulssignal einer Time-of-Flight-Messung;

Fig. 2A     schematische Diagramme zur Illustrierung des Verfahrens von Fig. 1 in einem ersten Zeitbereich;

Fig. 2B     schematische Diagramme zur Illustrierung des Verfahrens von Fig. 1 in einem zweiten Zeitbereich;

Fig. 3       ein Histogramm zur Ermittlung von kalibrierten Verzögerungszeiten für das Verfahren von Fig. 1.

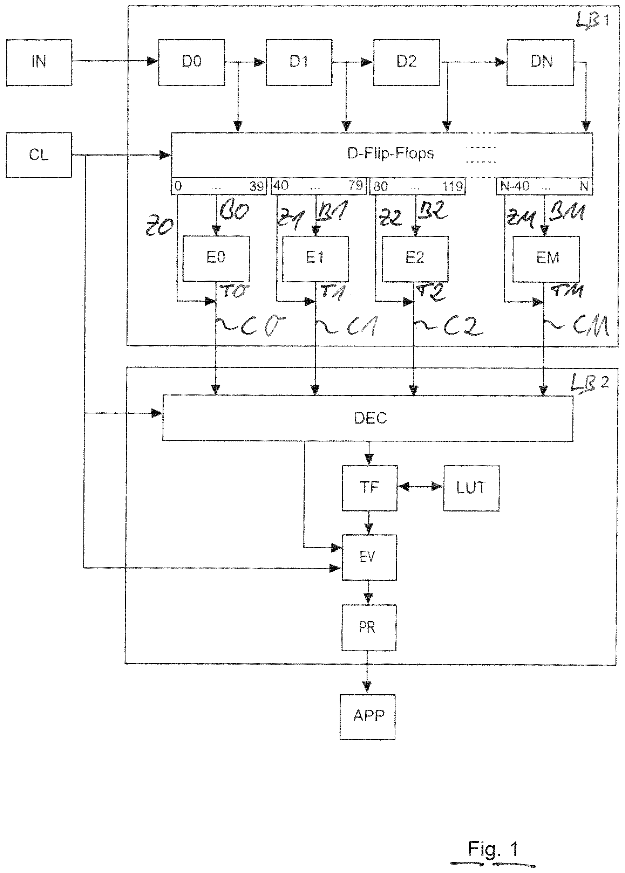

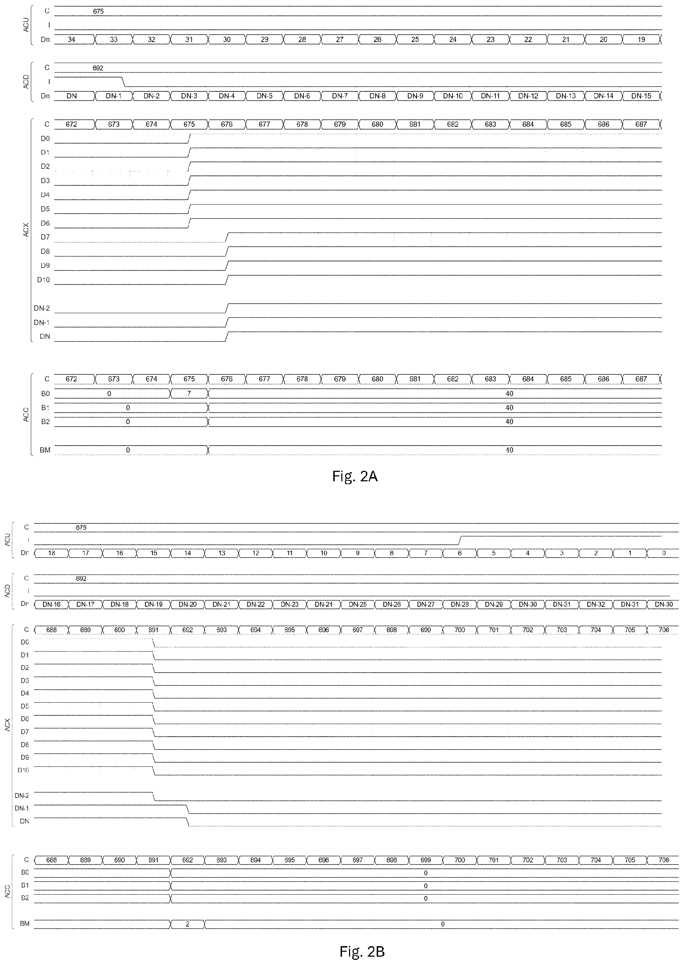

Mit Bezug auf Fig. 1 und Fig. 2A und 2B wird ein Verfahren zur Bestimmung von Zeitabständen aus einem Pulssignal I einer Time-of-Flight-Messung (ToF-Messung) beschrieben. Das Pulssignal I repräsentiert ein Empfangssignal einer ToF-Scanvorrichtung und umfasst eine Pulskette mit mehreren aufeinanderfolgenden Rechteckpulsen unterschiedlicher Breite. Die einzelnen Pulsflanken entsprechen jeweils sogenannten Up- oder Down-Events, die vorab durch Filterung des Empfangssignals mit einem Schwellenwert erzeugt werden, um Pulse in dem verrauschten Empfangssignal zu detektieren. Die Pulsflanken dienen insbesondere zur genauen zeitlichen Lokalisierung von Empfangspulsen, die auf Sendepulse der ToF-Scanvorrichtung zurückzuführen sind und zur Entfernungsbestimmung nach dem ToF-Messprinzip dienen.

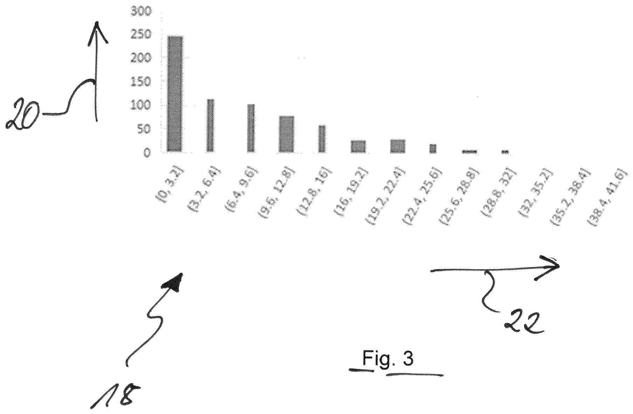

Das Pulssignal I wird in einem ersten logischen Block LB1 (Configurable Logical Block) eines FPGAs (Field Programmable Gate Array) mittels N hintereinandergeschalteter Verzögerungselemente D0, D1, D2, ...., DN verarbeitet, die zusammen eine Verzögerungsleitung (Delay-Line) bilden. Jedes Verzögerungselement Dn, das auch als Delay-Element bezeichnet werden kann, verzögert das Pulssignal I um eine vorbestimmte Verzögerungszeit. Die Verzögerungszeiten können sich zwischen den einzelnen Verzögerungselementen Dn unterscheiden und werden vorab im Rahmen eines Kalibrierungsprozesses ermittelt, der weiter unten im Zusammenhang mit Fig. 3 näher beschrieben wird.

Das Pulssignal I wird zwischen den Verzögerungselementen Dn in Abhängigkeit eines periodischen Taktsignals CL abgetastet. Das Taktsignal CL wird von einem zentralen Taktgeber (Clock) erzeugt und kann durch ein periodisches Rechtecksignal dargestellt werden. Zur Abtastung des Pulssignals I zwischen den Verzögerungselementen Dn weist der logische Block LB1 für die schematisch dargestellte Verzögerungsleitung insgesamt N D-Flip-Flops auf, die in Fig. 1 durch den Block D-Flip-Flops angedeutet sind. Jedes D-Flip-Flop speichert den jeweiligen Pegel (high oder low) des Pulssignals I zwischen zwei aufeinanderfolgenden Verzögerungselementen Dn durch ein Bit ab. Durch diese Art der Abtastung werden im Takt des Taktsignals CL jeweils Bitfolgen mit N Bits erzeugt. Die Bitfolgen repräsentieren jeweils das durch die Verzögerungsleitung durchlaufende Pulssignal I zum betreffenden Abtastzeitpunkt.

Die abgetasteten Bitfolgen werden jeweils in aufeinanderfolgende Blöcke Bm (m = 0, 1, 2, ..., M) von je 40 Bit Länge unterteilt, wobei in Abhängigkeit von der Abtastfrequenz bzw. Periodenlänge des Taktsignals CL auch andere Blocklängen gewählt werden können. Vorzugsweise ist die Blocklänge jedoch so kurz gewählt, dass innerhalb einer Periode jeweils maximal ein Bitzustandswechsel auftritt. In einem Beispiel beträgt die Abtastfrequenz 400 MHz, entsprechend einer Periodenlänge von 2500 ps. Bei einer mittleren Verzögerungszeit von 5 ps pro Verzögerungselement Dn sind zur Abdeckung einer Periodenlänge vorzugsweise 500 Verzögerungselemente vorgesehen, d.h. N = 500. Dementsprechend sind auf dem ersten logischen Block LB1 auch vorzugsweise 500 D-Flip-Flops implementiert, die zusammen für jede Periode des Taktsignals CL eine Bitfolge mit 500 Bits erzeugen. Es versteht sich, dass in verschiedenen ToF-Scanner-Anwendungen in Abhängigkeit der Sendepulsfrequenz und der gewünschten Messdistanz andere Zahlenwerte gewählt sein können.

Die Blöcke Bm werden zur Datenkompression jeweils in eine Binärzahl umgewandelt, die im Fall eine Blocklänge von 40 Bit vorzugsweise eine Länge von 6 Bit aufweist. Auf diese Weise werden M erste Teilcodewörter Tm (m = 0, 1, 2, ..., M) von je 6 Bit erzeugt (vgl. Kodierungsschritte E0, E1, E2,...., EM in Fig. 1). Die Binärzahl gibt die Anzahl gleichbleibender aufeinanderfolgender 1-Bitzustände des betreffenden Blocks Bm an. Hierbei ist zu berücksichtigen, dass ein Block mit zehn 0-Bits gefolgt von dreißig 1-Bits durch die gleiche Binärzahl dargestellt wird wie ein richtungsinverser Block mit dreißig 1-Bits gefolgt von zehn 0-Bits. Die Binärzahl für sich genommen lässt somit keinen Rückschluss darüber zu, ob der Block Bm einen Bitzustandswechsel von 0 auf 1 oder von 1 auf 0 enthält.

Um dennoch die Information über die Richtung der Bitzustandswechsel und damit die Polarität der korrespondierenden Pulsflanke blockweise mit M Codewörtern Cm (m = 0, 1, 2, ..., M) zu übertragen, werden die Teilcodewörter Tm jeweils zumindest mit dem ersten Bit Zm (m = 0, 1, 2, ..., M) des zugrundeliegenden Blocks Bm verkettet. Jedes Codewort Cm enthält somit eine Information darüber, ob der betreffende Block Bm mit einer 0 oder 1 begonnen hat. Zusammen mit der durch die Binärzahl angegebenen Anzahl von 1-Bits lassen sich im Zuge der Decodierung (vgl. DEC in Fig. 1) die Position und die Richtung eines Bitzustandswechsels ermitteln. Hierbei wird wie erläutert angenommen, dass pro Block Bm nur ein regulärer Bitzustandswechsel auftritt. Irreguläre Bitzustandswechsel können z.B. durch Fehlerkorrektur gefiltert werden.

Ein beispielhafter Codierungsablauf wird nachfolgend unter Bezugnahme auf Fig. 2A und 2B beschrieben. Fig. 2B stellt eine zeitliche Fortsetzung von Fig. 2A dar. Die Abtastperiode wird durch einen Grobzähler C identifiziert, der mit jeder Abtastperiode des Taktsignals CL weiterzählt. In einem Diagramm ACU von Fig. 2A und 2B steht der Grobzähler C bei einem Zählerstand von C = 675. Während dieser Abtastperiode weist das Pulssignal I von dem Verzögerungselement D0 bis zu dem Verzögerungselement D6 den hohen Pegel auf (vgl. Fig. 2B), für die Verzögerungselemente D7 bis DN hingegen den niedrigen Pegel (vgl. Fig. 2A und 2B, dargestellt bis Dn = 34). Dieser Zustand ist auch in einem Diagramm ACX verdeutlicht, das sich über mehrere Abtastperioden des Grobzählers C erstreckt. In dem Diagramm ACX ist zu erkennen, dass in dem Grobzählerschritt 675 die Verzögerungselemente D0 bis D6 von 0 auf 1 springen. Die übrigen Verzögerungselemente D7 bis DN weisen jedoch noch den Wert 0 auf. Die durch Abtastung der Verzögerungsleitung erhaltene Bitfolge weist dementsprechend im ersten Block B0 (Bits 0 bis 39) sieben 1-Bits (Bitzustand = 1) gefolgt von dreiundreißig Null-Bits (Bitzustand = 0) auf.

Die Codierung der Blöcke Bm wird anhand des Codierungsdiagramms ACC in Fig. 2A und 2B weiter beschrieben. Der erste Block B0 der Bitfolge (Bits 0 bis 39) bildet für C = 675 ein unäres Codewort, das 7 gleiche aufeinanderfolgende 1-Bits aufweist. Der Block B0 wird zur komprimierten Darstellung dieser Information in eine Binärzahl umgewandelt, die das Teilcodewort T0 = 000111 bildet. Dies entspricht der Dezimalzahl 7, vgl. Diagramm ACC in Fig. 2A. Das Teilcodewort T0 wird zu Codierung der Position und Richtung des Bitzustandswechsels mit dem ersten Bit Z0 des zugrundeliegenden Blocks B0 verkettet, d.h. es ergibt sich das Codewort C0 = 000111 1. Die übrigen Blöcke B1, B2, ..., BM weisen bei C = 675 hingegen keinen Bitzustandswechsel auf, sodass die entsprechenden Codewörter C1, C2, ..., CM jeweils 000000 0 sind. Das Diagramm ACC weist für die Blöcke B1, B2, ..., BM folglich jeweils eine 0 aus. Die gleichen Blöcke werden in den vorhergehenden Grobzählerschritten C = 672, 673 und 674 ebenfalls durch die Codewörter 000 000 0 dargestellt.

Für die Grobzählerwerte C = 676 bis 691 ist die in dem Diagramm ACX dargestellte Pulsflanke des Pulssignals I aus Zählerschritt C = 675 (vgl. Diagramm ACU) vollständig durch die Verzögerungsleitung gelaufen, sodass alle Verzögerungselemente D0 bis DN mit 1-Bits abgetastet werden. Dementsprechend weisen alle Blöcke B0 bis BM durchgehend 1-Bits auf. Die Blöcke von je 40 Bit werden folglich jeweils durch Codewörter 101000 1 dargestellt. Das Teilcodewort 101000 entspricht im Dezimalsystem einer 40, vgl. Diagramm ACC.

Bei Erreichen des Grobzählerwerts 692 werden nach den Verzögerungselementen D0 bis DN-2 jeweils wieder 0-Bits abgetastet. Nur hinter den letzten beiden Verzögerungselementen DN-1 und DN liegen noch 1-Bits an. Dementsprechend wird bei C = 692 lediglich der letzte Block M mit einem von Null verschiedenen Teilcodewort codiert, das im Diagramm ACC für den Block BM durch die Dezimalzahl 2 angedeutet (entsprechend zwei gleichen aufeinanderfolgende 1-Bits). Es ergibt sich das Codewort CM= 000010 0. Die zugehörige Pulsflanke des Pulssignals I ist in einem Diagramm ACD dargestellt, das einen Ausschnitt der Abtastperiode C = 692 zeigt und die fallende Pulsflanke bei dem Verzögerungselement Dn = DN-1 aufweist.

Die vorstehend beschriebenen Codierungsaspekte sind in der nachfolgenden Tabelle 1 zusammengefasst. Abweichend werden die Teilcodewörter Tm zusätzlich zu dem jeweils ersten Bit des Blocks Bm mit dem jeweils letzten Bit des Blocks Bm verkettet, um die Redundanz zu Fehlerkorrekturzwecken zu erhöhen. Die Codewörter Cm umfassen somit jeweils 8 Bit, die aufgrund der standardisierten Datengröße von 1 Byte besonders effizient übertragen werden können.

Tabelle 1

| Grobzähler C, Block Bm | Erstes Teilcodewort | Zweites Teilcodewort | Codewort |
|---|---|---|---|
| C: 672 bis 674<br>Bm: B0 bis BM | 000 000 | 00 | 000 000 00 |
| C: 675, B0 | 000 111 | 10 | 000 111 10 |
| C = 675<br>Bm: B1 bis BM | 000 000 | 00 | 000 000 00 |
| C = 676 bis 691<br>Bm: B0 bis BM | 101 000 | 11 | 101 000 11 |
| C = 692 bis 706<br>Bm: B0 bis BM-1 | 000 000 | 00 | 000 000 00 |
| C = 692<br>Bm: BM | 000 010 | 01 | 000 010 01 |
| C = 693 bis 706<br>Bm: BM | 000 000 | 00 | 000 000 00 |

Die für die jeweiligen Blöcke gebildeten zweiten Teilcodewörter Zm (m = 0, 1, 2, ..., M) können für jede Abtastperiode zusammen betrachtet werden, um Blöcke mit Bitzustandswechseln zu identifizieren. Die verketteten zweiten Teilcodewörter Zm ergeben pro Abtastperiode einen sogenannten Hit-Vektor, der einen oder mehrere Blöcke Bm ausweist, die von einem Bitzustandswechsel betroffen sind. Für die Abtastperiode C = 675 ergibt sich beispielsweise ein Hit Vector V = <1000....0>, der unmittelbar angibt, dass in dieser Abtastperiode im ersten Block B0 ein Bitzustandswechsel von 1 auf 0 vorliegt. Da sich die 1-Bits am Anfang des Blocks befinden, wird hierdurch eine negative Flanke des Eingangssignals I angezeigt, was einem Up-Event auf der Ebene der Abtastung entspricht, vgl. Diagramme ACU und ACX in Fig. 2A und 2B. Umgekehrt weist der Hit-Vektor V = <00....001> für die Abtastperiode C = 692 im letzten Block BM einen Bitzustandswechsel von 0 auf 1 aus. Dies korrespondiert mit einer positiven bzw. steigenden Flanke des Eingangssignals I, was einem Down-Event auf der Ebene der Abtastung entspricht, vgl. Diagramm ACD in Fig. 2A und Diagramm ACX in Fig. 2B.

Die Codewörter Cm werden von einem zweiten logischen Block LB2 decodiert, der die Codewörter Cm von dem ersten logischen Block LB1 empfängt, vgl. DEC in Fig. 1. Alternativ können die Erzeugung der Codewörter Cm sowie deren Decodierung in einem einzigen logischen Block des FPGAs implementiert werden. Durch Berücksichtigung der ersten und zweiten Teilcodewörter Tm, Zm werden nicht nur die von einem Bitzustandswechsel betroffenen Blöcke Bm identifiziert, sondern auch die Position und Richtung der Bitzustandswechsel innerhalb der Blöcke Bm. Dies wird anhand des folgenden Beispiels verdeutlicht: Weist der zehnte Block B9 zwölf 1-Bits und alle vorherigen neun Blöcke jeweils vierzig 0-Bits auf, so befindet sich eine fallende Signalflanke des Eingangssignals I im zehnten Block B9. Der Block B9 gibt ausweislich des betreffenden Codeworts C9 den Bitzustandswechsel zwischen den Bits 12 und 13 an. Die fallende Signalflanke kann auf diese Weise mit der Formel 9*40 + 12 = 372 an dem Verzögerungselement D372 lokalisiert werden.

Es ist denkbar, dass innerhalb einer Abtastperiode mehrere Bitzustandswechsel auftreten. Dies bedeutet, dass mehrere Blöcke Bm der Bitfolge Bitzustandswechsel aufweisen können. Diese Informationen können ebenfalls durch den Hit-Vektor dargestellt werden. Beispielsweise weist ein Hit-Vektor V = <01100110> zwei Pulse mit insgesamt vier Pulsflanken aus, die detektierbar und unter Berücksichtigung der Codewörter Cm in den betroffenen Blöcken lokalisierbar sind.

Zur Umrechnung eines mit einem Bitzustandswechsel korrespondierenden Verzögerungselements Dn in einen Zeitwert DZ werden die Verzögerungszeiten Di aller vorgeschalteten Verzögerungselemente einschließlich des identifizierten Verzögerungselements aufaddiert. Für das oben beschriebene Beispiel des von einem Bitzustandswechsel betroffenen Verzögerungselements D372 kann die Berechnung des Zeitwerts DZ (Delay-Zeit) als Summe der Verzögerungszeiten Di mit der Laufvariable j wie folgt ausgedrückt werden:

$$DZ = \sum_{j=0}^{372} D_j.$$

Der Zeitwert DZ gibt den Zeitpunkt des Bitzustandswechsels in Bezug auf den Beginn der Abtastperiode an und kann dementsprechend als Feinwert angesehen werden. Der Feinwert DZ wird zusammen dem Grobzählerwert C der betreffenden Abtastperiode in einen Zeitwert umgerechnet, der den Zeitpunkt des Bitzustandswechsel in Bezug auf die Systemzeit angibt.

Die Verzögerungszeiten Di sind individuell für jedes Verzögerungselement Dn verschieden. Sie werden vorab durch Kalibrierung der Verzögerungsleitung ermittelt. Die Kalibrierung erfolgt unter Verwendung eines Kalibriersignals, das fiktive Messzeiten erzeugt, in denen alle Verzögerungszeiten gleichverteilt vorkommen. Das Kalibriersignal kann z.B. aus einer unabhängigen Zeitreferenz generiert werden, deren Frequenz wesentlich kleiner als die Abtastfrequenz des Taktsignals CL ist und sich von dieser durch einen irrationalen Faktor unterscheidet. Das Kalibriersignal wird durch die Verzögerungsleitung analog zu dem Pulssignal I verarbeitet, wobei die Up- und Down-Events für jedes Verzögerungselement Dn gezählt werden. Dies bedeutet, dass für jedes Verzögerungselement Dn eine Anzahl von Events erfasst wird, die dieselbe Verzögerungszeit Di aufweisen. Es kann auf diese Weise ein Histogramm 18 ermittelt werden, das rein beispielhaft in Fig. 3 gezeigt ist. Das Histogramm 18 wurde ermittelt für ein Beispiel, in dem die Verzögerungselemente in einem ersten logischen Block eines FPGAs implementiert sind. Die Vertikalachse 20 des Histogramms 18 repräsentiert eine Anzahl von Treffern von Up- und Down-Events. Die Horizontalachse 22 gibt die gemessenen Verzögerungszeiten an, die in dem Histogramm 18 in Schrittweiten von 3,2 ps gruppiert sind. Es ist zu erkennen, dass die meisten Verzögerungselemente eine Verzögerungszeit zwischen 0 und 3,2 ps aufweisen. Die Anzahl von Verzögerungselementen mit längeren Verzögerungszeiten nimmt in Richtung der Achse 22 exponentiell ab.

Aus den Daten der Kalibrierungsmessung wird für jedes Verzögerungselement Dn eine normierte kalibrierte Verzögerungszeit Di ermittelt, indem die Anzahl von Events für das betreffende Verzögerungselement (= Anzahl von Treffern bzw. Hits) durch die Gesamtanzahl von Events aller Verzögerungselemente dividiert und mit der Periodenlänge $P_{Clock}$ des Taktsignals CL multipliziert wird:

$$D_i = \frac{Hits_i}{\sum_{j=1}^{N} Hits_j} \cdot P_{Clock}.$$

Auf diese Weise wird jedem Verzögerungselement Dn eine vorbestimmte Verzögerungszeit Di (i=n) zugeordnet, die zusammen in einer Look-up-Tabelle (LUT) hinterlegt werden können.

Die Look-up-Tabelle LUT wird herangezogen, um die bei der Decodierung DEC identifizierten Verzögerungselemente Dn in Zeitdauern umzurechnen. Dies ist in Fig. 1 durch die Zeitdauerberechnung TF angedeutet. Im nachfolgenden Schritt EV werden sodann Zeitabstände zwischen gegenläufigen Bitzustandswechseln ermittelt, die sich jeweils aus der Differenz der für die Bitzustandswechsel ermittelten Zeitdauern ergeben. Die gegenläufigen Paare aus Bitzustandswechsels sind wegen der decodierten Richtungsinformation der Codewörter Cm bekannt. Beispielsweise kann der Zeitabstand zwischen einer positiven und negativen Signalflanke ermittelt werden, um eine Breite eines Empfangspulses zu schätzen.

Die im Schritt EV ermittelten Zeitabstände können in einem nachfolgenden Schritt PR gefiltert werden, um z.B. nicht plausible Zeitabstände zu entfernen. Beispielsweise können Zeitabstände gefiltert werden, die eine erwartbare Pulsbreite oder eine erwartbare Round-Trip-Zeit der ToF-Messung zwischen Sende- und zugehörigen Empfangspulsen überschreiten. Solche und andere Fehlmessungen können von der weiteren Verarbeitung ausgeschlossen werden, insbesondere vor einer Umrechnung der Zeitabstände in Entfernungswerte.

Die erhaltenen Zeitinformationen werden von dem zweiten logischen Block des FPGAs an eine weiterverarbeitende Anwendung übertragen. Eine solche Anwendung kann z.B. die Überwachung von Schutzvolumen auf der Grundlage von dreidimensionalen Entfernungsbildern betreffen. Die in Fig. 1 skizzierte Messeinrichtung und das zugehörige Verfahren können jedoch universell in einer Vielzahl von ToF-Scannern vorteilhaft eingesetzt werden.

BEZUGSZEICHENLISTE

| | |
|---|---|
| 18 | Histogramm |
| 20 | Anzahl Treffer |
| 22 | Verzögerungszeiten |

| | |
|---|---|
| ACU | Ausschnitt einer Abtastperiode Up-Event |
| ACD | Ausschnitt einer Abtastperiode Down-Event |
| ACC | Codierung |
| ACX | Ausschnitt mehrerer Abtastperioden |
| APP | Anwendungsbezogene Auswertung |
| Bm | m-ter Block |
| C | Grobzähler |
| Cm | m-tes Codewort |
| CL | Zeitreferenzsignal |
| Dn | n-tes Verzögerungselement |
| DEC | Decodierung |
| Em | m-te Codierung |
| EV | Zeitabstandbestimmung |
| LB1 | Erster logischer Block |
| LB2 | Zweiter logischer Block |
| PR | Filterung |
| TF | Zeitdauerbestimmung |
| Tm | m-tes Teilcodewort |
| Zm | m-te Bitzustandsinformation |

**Patentansprüche**

1. Verfahren zum Bestimmen von Zeitinformation aus einem Pulssignal (I), das eine Time-of-Flight-Messung repräsentiert, wobei das Verfahren zumindest folgende Schritte aufweist:

   - Filtern des Pulssignals (I) mit mehreren hintereinandergeschalteten Verzögerungselementen (Dn);
   - Erzeugen einer Bitfolge, indem das Pulssignal (I) zwischen den Verzögerungselementen (Dn) in Abhängigkeit einer periodischen Zeitreferenz (CL) abgetastet wird;
   - Erzeugen von mehreren Codewörtern (Cm), die jeweils einem von mehreren aufeinanderfolgenden Blöcken (Bm) der Bitfolge zugeordnet sind, wobei die Codewörter (Cm) jeweils eine Anzahl gleicher aufeinanderfolgender Bitzustände des zugeordneten Blocks (Bm) repräsentieren, und wobei den Codewörtern (Cm) jeweils eine Bitzustandsinformation (Zm) des zugeordneten Blocks (Bm) hinzugefügt wird; und
   - Bestimmen der Zeitinformation auf der Grundlage der mehreren Codewörter (Cm) in Abhängigkeit von der Zeitreferenz (CL).

2. Verfahren nach Anspruch 1,
   wobei zumindest das Filtern des Pulssignals (I), das Erzeugen der Bitfolge sowie das Erzeugen der Codewörter (Cm) von einem ersten logischen Block (LB1) eines integrierten Schaltkreises ausgeführt werden, und wobei das Bestimmen der Zeitinformation von einem zweiten logischen Block (LB2) des integrierten Schaltkreises ausgeführt wird.

3. Verfahren nach Anspruch 2,
   wobei der integrierte Schaltkreis durch ein Field Programmable Gate Array gebildet ist.

4. Verfahren nach einem der vorhergehenden Ansprüche, wobei zumindest einige der Codewörter (Cm) jeweils ein erstes Teilcodewort (Tm) und ein zweites Teilcodewort (Zm) umfassen, wobei das erste Teilcodewort (Tm) eine Binärzahl aufweist, welche die Anzahl gleicher aufeinanderfolgender Bitzustände des zugeordneten Blocks (Bm) angibt, und wobei das zweite Teilcodewort (Zm) die Bitzustandsinformation angibt, indem das zweite Teilcodewort (Zm) zumindest ein vorbestimmtes Bit des zugeordneten Blocks (Bm) enthält.

5. Verfahren nach Anspruch 4,
wobei das zweite Teilcodewort (Zm) durch das erste Bit und/oder das letzte Bit des zugeordneten Blocks (Bm) gebildet wird, insbesondere wobei das zweite Teilcodewort (Zm) zusätzlich zu dem ersten Bit und/oder letzten Bit des zugeordneten Blocks (Bm) ein Prüfsummenbit aufweist, das vorzugsweise durch das letzte Bit der Bitfolge gebildet wird.

6. Verfahren nach einem der vorhergehenden Ansprüche, wobei eine Länge der Codewörter (Cm) jeweils kleiner als eine Länge der zugeordneten Blöcke (Bm) ist, insbesondere wobei die Länge der Codewörter (Cm) und die Länge der zugeordneten Blöcke (Bm) jeweils konstant sind, wobei die Länge der Codewörter (Cm) vorzugsweise jeweils 8 Bit und/oder die Länge der Blöcke (Bm) vorzugsweise jeweils 40 Bit beträgt.

7. Verfahren nach einem der vorhergehenden Ansprüche, wobei das Bestimmen der Zeitinformation umfasst:

   - Ermitteln, in Abhängigkeit der mehreren Codewörter (Cm), eines ersten Verzögerungselements (Dn), das mit einem ersten Bitzustandswechsel der Bitfolge korrespondiert und einen ersten Puls des Pulssignals (I) repräsentiert;
   - Bestimmen einer ersten Zeitdauer (DZ), indem vorbestimmte Verzögerungszeiten (Di) des ersten Verzögerungselements (Dn) und aller vorgeschalteten Verzögerungselemente (Dn) addiert werden;
   - Ermitteln, in Abhängigkeit der mehreren Codewörter (Cm), eines zweiten Verzögerungselements (Dn), das mit einem zweiten Bitzustandswechsel der Bitfolge korrespondiert und einen zweiten Puls des Pulssignals (I) repräsentiert, wobei der zweite Bitzustandswechsel ausweislich der Bitzustandsinformationen (Zm) der Codewörter (Cm) gegenläufig zu dem ersten Bitzustandswechsel ist;
   - Bestimmen einer zweiten Zeitdauer, indem vorbestimmte Verzögerungszeiten (Di) des zweiten Verzögerungselements (Dn) und aller vorgeschalteten Verzögerungselemente (Dn) addiert werden; und insbesondere
   - Bestimmen eines Zeitabstands zwischen dem ersten Bitzustandswechsel und dem zweiten Bitzustandswechsel, indem die erste Zeitdauer und die zweite Zeitdauer subtrahiert werden.

8. Verfahren nach Anspruch 7,
wobei jede der vorbestimmten Verzögerungszeiten (Di) einem der Verzögerungselemente (Dn) zugeordnet und für das betreffende Verzögerungselement (Dn) kalibriert ist.

9. Verfahren nach einem der vorhergehenden Ansprüche,
wobei das Pulssignal (I) bestimmt wird, indem ein Empfangssignal der Time-of-Flight-Kamera mit einem Komparator gefiltert wird, um eine Pulskette mit mehreren positiven und negativen Pulsflanken zu erhalten.

10. Messeinrichtung zum Bestimmen von Zeitinformation aus einem Pulssignal (I), das eine Time-of-Flight-Messung repräsentiert, wobei die Messeinrichtung dazu angepasst ist, das Verfahren nach einem der vorhergehenden Ansprüche auszuführen.

11. Messeinrichtung nach Anspruch 10,
umfassend einen ersten logischen Block (LB1) eines integrierten Schaltkreises und wenigstens einen zweiten logischen Block (LB1) des integrierten Schaltkreises, wobei der erste logische Block (LB1) mehrere hintereinandergeschaltete Verzögerungselemente (Dn) zur Filterung des Pulssignals (I) sowie mehrere Flipflops zur Erzeugung einer Bitfolge aufweist, die durch Abtastung des Pulssignals (I) zwischen den Verzögerungselementen (Dn) erhalten ist, wobei der zweite logische Block (LB2) dazu angepasst ist, Zeitinformation auf der Grundlage mehrerer Codewörter (Cm) zu bestimmen, die jeweils einem von mehreren aufeinanderfolgenden Blöcken (Bm) der Bitfolge zugeordnet sind, jeweils eine Anzahl gleicher aufeinanderfolgender Bitzustände des zugeordneten Blocks (Bm) repräsentieren und jeweils eine Bitzustandsinformation des zugeordneten Blocks (Bm) enthalten.

12. Messeinrichtung nach Anspruch 10 oder 11,
wobei der integrierte Schaltkreis durch ein Field Programmable Gate Array gebildet ist.

13. Time-of-Flight-Scanner zur Aufnahme von jeweils eine Vielzahl von Entfernungsbildpunkten aufweisenden Entfernungsbildern, umfassend eine Mehrzahl von in einem Array angeordneten Sendern jeweils zur Aussendung von elektromagnetischer Strahlung in einen Aufnahmebereich und zumindest eine Empfangseinrichtung zur Detektion von aus dem Aufnahmebereich reflektierter Strahlung, eine Messeinrichtung nach einem der Ansprüche 10 bis 12 zum Bestimmen von Zeitinformation aus einem Pulssignal (I), das eine Time-of-Flight-Messung repräsentiert und herangezogen wird, um jeweils einen Entfernungsbildpunkt bildende Entfernungen von Objekten zu bestimmen, an denen die ausgesandte Strahlung reflektiert wird.

Fig. 1

Fig. 2A

Fig. 2B

Fig. 3

Europäisches
Patentamt

European
Patent Office

Office européen
des brevets

# EUROPÄISCHER RECHERCHENBERICHT

Nummer der Anmeldung

EP 24 19 4678

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2019 102254 A1 (GSI HELMHOLTZZENTRUM SCHWERIONENFORSCHUNG GMBH [DE]) 30. Juli 2020 (2020-07-30) * Absätze [0155], [0012], [0110], [0092]; Anspruch 1 * ----- | 1,2,6,7, 9-11,13 | INV. G01S7/4865 G04F10/00 |
| X | WU BO ET AL: "Design of Time-to-Digital Converters for Time-Over-Threshold Measurement in Picosecond Timing Detectors", IEEE TRANSACTIONS ON NUCLEAR SCIENCE, IEEE, USA, Bd. 68, Nr. 4, 18. Februar 2021 (2021-02-18), Seiten 470-476, XP011849817, ISSN: 0018-9499, DOI: 10.1109/TNS.2021.3060069 [gefunden am 2021-04-15] * Zusammenfassung; Abbildungen 1,2 * * Kapitel I., II.A., II.B. * ----- | 1-13 | |
| A,D | EP 1 901 093 A1 (TRIPLE IN HOLDING AG [CH]) 19. März 2008 (2008-03-19) * Ansprüche 1,5,6,35 * ----- | 7,9,13 | RECHERCHIERTE SACHGEBIETE (IPC) G01S G04G G04F |

Der vorliegende Recherchenbericht wurde für alle Patentansprüche erstellt

| Recherchenort | Abschlußdatum der Recherche | Prüfer |
|---|---|---|
| München | 17. Januar 2025 | Grübl, Alexander |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 19 4678

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

17-01-2025

| Im Recherchenbericht angeführtes Patentdokument | Datum der Veröffentlichung | Mitglied(er) der Patentfamilie | Datum der Veröffentlichung |
|---|---|---|---|
| DE 102019102254 A1 | 30-07-2020 | DE 102019102254 A1 | 30-07-2020 |
| | | EP 3918426 A1 | 08-12-2021 |
| | | ES 2993207 T3 | 26-12-2024 |
| | | WO 2020156701 A1 | 06-08-2020 |
| EP 1901093 A1 | 19-03-2008 | EP 1901093 A1 | 19-03-2008 |
| | | JP 2008076390 A | 03-04-2008 |
| | | US 2008186470 A1 | 07-08-2008 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1522870 A1

- EP 1901093 B1